# EUROPEAN PATENT SPECIFICATION

(11) **EP 1 548 812 B1**
(45) Date of publication and mention of the grant of the patent: **22.07.2009**
(21) Application number: 04029853.1
(22) Date of filing: 16.12.2004
(51) Int. Cl.: H01L 21/306

(54) **High-purity alkali etching solution for silicon wafers and alkali etching method of silicon wafer**
Hoch reine alkalische Ätzenlösung für Silizium-Wafern und alkalisches Ätzverfahren eines Silizium-Wafers
Solution gravure alcaline de haute pureté pour des tranches de silicium et procédé pour gravure alcaline d'une tranche de silicium

(30) Priority: 22.12.2003 JP 2003425672
(43) Date of publication of application: 29.06.2005
(73) Proprietor: Siltronic AG, 81737 München (DE)
(72) Inventor: Nishimura, Shigeki, Hikari Yamaguchi, 743-0075 (JP)
(74) Representative: Staudacher, Wolfgang

(56) References cited:
- EP-A- 1 168 423
- US-B1- 6 346 485
- PATENT ABSTRACTS OF JAPAN vol. 1999, no. 11, 30 September 1999 (1999-09-30) -& JP 11 150106 A (TOSHIBA CERAMICS CO LTD), 2 June 1999 (1999-06-02)
- PATENT ABSTRACTS OF JAPAN vol. 1999, no. 11, 30 September 1999 (1999-09-30) & JP 11 162953 A (MITSUBISHI MATERIALS SILICON CORP), 18 June 1999 (1999-06-18)

## Description

The present invention relates to a method of etching a silicon wafer with an alkali etching solution.

In case of producing a silicon wafer, for e.g. an integrated circuit of an IC or an LSI and an individual semiconductor device of a transistor or a diode, the silicon wafer can be produced by cutting a single crystal obtained by Czochralski method (CZ method) or Floating Zone method (FZ method) with an inner blade saw or a wire saw, chamfer processing on peripheral part thereof, lap processing with free abrasives of main surface for improvement of the surface flatness thereof and then, wet etching the wafer for eliminating the process distortion which is subjected to the wafer during this process; and after that conducting mirror polishing of the wafer. One of the wet etching which eliminates this process distortion is alkali etching using an alkali such as sodium hydroxide and potassium hydroxide. Such alkali etching has the advantage of obtaining good surface flatness of the wafer after etching since the alkali etching has a slow-etching rate, and has the disadvantage of diffusing metal impurities included the alkali etching solution into the inner wafer during the alkali etching process.

The present invention has the object to provide a method of etching a silicon wafer which avoids drawbacks of the alkali etching process.

According to EP 1 168 423 A1 immersing stainless steel in an alkali aqueous solution significantly reduces metallic elements dissolved in such etchant.

According to JP 11-150106 A the occurrence of blur on the surface of a silicon wafer can be prevented by adding a small amount of alkali salt nitrite to a caustic alkali aqueous solution as etchant.

According to US 6 346 485 B1 the depth of pits can be reduced more effectively when nitrite such as NaNO₂ is added to an alkali etchant.

According to JP 11-162953 A flatness and surface roughness of a silicon wafer are improved by immersing the wafer in an etchant prepared by adding metallic salt such as a nitrate, sulfate or chloride of Cu, Ni or Fe, and other components into an alkali aqueous solution.

The present inventors have found that the drawbacks above-mentioned can be cleared by the claimed method.

That is, the alkali etching solution used according to the present invention as claimed contains a sodium hydroxide solution and 0.01 to 10 wt% of nitrate of sodium, potassium or lithium. The sodium hydroxide has 1 ppb or less of the element content of Cu, Ni, Mg, and Cr, 5 ppb or less of the element content of Pb and Fe, 10 ppb or less of the element content of Al, Ca, and Zn, 1 ppm or less of chloride, sulfate, phosphate, and nitrogen compound.

Etching of the silicon wafer by using the alkali etching solution achieves 1 × 10¹⁰ atoms/cm² or less of amount of heavy metal adhesion on the wafer after etching and 1 µm or less of degradation of the surface flatness (Δ TTV = TTV before etching - TTV after etching).

The alkali etching solution used according to the present invention comprises high-purity sodium hydroxide containing very few of metal impurities. Moreover, the presence of nitrate of sodium, potassium or lithium in the alkali etching solution allows a control of the appearance of uneven etching and allows to produce the silicon wafer having 1 ppb or less of the element content of Cu, Ni, Mg, and Cr, 5 ppb or less of the element content of Pb and Fe, 10 ppb or less of the element content of Al, Ca, and Zn, 1 ppm or less of chloride, sulfate, phosphate, nitrogen compound and having extremely great surface flatness.

The alkali etching solution used according to the present invention differs from the etching solution for alkali etching used conventionally, and comprises a sodium hydroxide solution with sodium hydroxide containing extremely few of metal impurities, both of nonionic and ionic forms, not restrained by kinds of metal. All known metals which are diffused in the inner wafer at the alkali etching and degrade the quality of the wafer are included. In particular, transition metals are included. Among them, in particular, iron, nickel, copper, and chromium are included.

And "containing very few of metal impurities" herein refers those of 1 ppb or less of the element content of Cu, Ni, Mg, and Cr, 5 ppb or less of the element content of Pb and Fe, 10 ppb or less of the element content of Al, Ca, and Zn, 1 ppm or less of chloride, sulfate, phosphate, and nitrogen compound, but the less being contained, the better.

The concentration of sodium hydroxide in the alkali etching solution is 40 to 60 wt%.

A suitable sodium hydroxide solution can be obtained by using a chemical and/or electrochemical method that has conventionally known objected to the high-purity. Specifically, the electrochemical method (Japanese Patent No. 3380658) can be included. Or eliminating metal impurities from a sodium hydroxide solution containing 1 ppb or more of the metal impurities which is produced by conventional method to 1 ppb or less of the metal impurities can be allowed.

Another feature of the alkali etching solution used according to the present invention is that 0.01 to 10 wt% of nitrate of sodium, potassium or lithium, is added to the high-purity sodium hydroxide solution for controlling so-called uneven etching which may appear on the silicon wafer surface. This is based on the findings obtained by the present inventors followed below. That is, the etching using the high-purity sodium hydroxide solution above explained provides the silicon wafer having extremely low amount of metal impurities, but also causes the so-called uneven etching on the silicon wafer surface, which degrades the surface flatness after the etching extremely. Consequently, the present inventors have found that the uneven etching can be controlled by adding 0.01 to 10 wt% of nitrate of sodium, potassium or lithium, to the sodium hydroxide solution.

Acids can be added to the alkali solution. In this case, desired concentration of nitrate of sodium, potassium or lithium is produced by neutralization.

The alkali etching solution for high-purity silicon wafer used according to the present invention can be kept as conventional alkali etching solution.

The alkali etching method according to the present invention comprises using the alkali etching solution above explained.

The etching conditions used in the alkali etching method according to the present invention are not restrained particularly. The conditions used for ordinary known alkali etching solution can be used preferably. Specifically, an etching concentration, an amount of etching solution, an etching time, temperature, and an agitation and the like are included.

Moreover, equipments used in the alkali etching method according to the present invention are not restrained particularly. The equipments used for ordinary known alkali etching solution can be used preferably. In particular, it' s to be noted the amount of the metal impurities contaminated from the equipments to the alkali etching solution.

The silicon wafers produced by using the present invention not only have extremely low amount of metal impurities contamination but also have very excellent surface flatness.

Types and amount of the metal impurities and the degree of diffusion of the metal impurities into the wafer can be estimated by variety of the measure means known conventionally. Specifically, atomic absorption spectrometry and inductively coupled plasma-mass spectrometry are included. Moreover, the surface flatness of the silicon wafer also can be estimated by variety of the measure means known conventionally. Specifically, Ultra scan made by ADE corporation and MX302 made by E+H corporation are included.

The present invention will be explained in detail by examples below.

### Examples:

### Example 1:

An alkali etching solution was prepared by dissolving 0.05 wt% of sodium nitrate (top grade reagent; made by Wako Pure Chemical Industries, Ltd.) to 48 wt% alkali concentration high-purity sodium hydroxide (CLEARCUT-S 48%; made by Tsurumi Soda Co., ltd) solution. The prepared alkali etching solution was poured into a square etching-processing bath of 15L content. 200mm diameter silicon wafer conducted lapping process was loaded to the carrier and dipped in the alkali etching solution. 25µm etching was conducted by processing this wafer for 7 to 11 minutes at 85°C of solution temperature. Then, the wafer was transferred to a washing bath to be washed and dried.

By tests described below, the etching rate, the visible test, the roughness, the glossiness, the ΔTTV, the amount of metal adhesion with the wafer surface of the resulting wafer was measured. The obtained results were summarized in Table 1. The visible tests, the roughness, the glossiness, the ΔTTV were conducted according below.
(1) Etching rate: (thickness before etching - thickness after etching) / etching time
   Furthermore, the thickness of a wafer is measured as an average thickness or a center thickness. In this example, the center thickness was employed.
(2) Visible test: 105, 000 lux of light was exposed on the wafer by halogen lamp in a darkroom, and the presence or absence of uneven etching was observed by the naked eye.
(3) Roughness: Ra was measured by SJ-201P (made by Mitutoyo Corporation.).
(4) Glossiness: Measured by PG-1M (made by Nippon Denshoku Industries Co., Ltd.)
(5) ΔTTV: TTV after etching - TTV before etching.
(6) The amount of metal adhesion with the wafer surface : Measured by atomic absorption spectrometry or ICP-MS (inductively coupled plasma-mass spectrometry).

### Example 2:

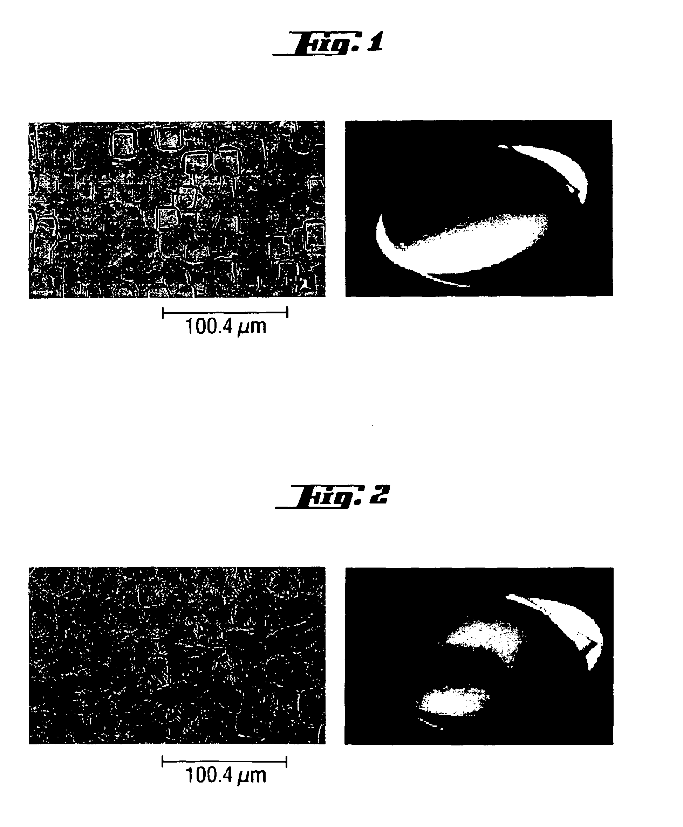

An etching solution was prepared same as Example 1 but the concentration of sodium nitrate was 0.1 wt%. Moreover, the etching process of the silicon wafer was conducted same as example 1. The etching rate, the visible test, the roughness, the glossiness, the ΔTTV, the amount of metal adhesion with the wafer surface of the resulting wafer was measured by the following test methods. The obtained results were summarized in Table 1. And a photograph at the visual check and measured results of uneven etching on the surface of the wafer observed by an electronic microscope (1250 ×) were shown in Figure 1.

### Example 3:

An etching solution was prepared same as Example 1 but the concentration of sodium nitrate was 1.0 wt%. Moreover, the etching process of the silicon wafer was conducted same as example 1. The etching rate, the visible test, the roughness, the glossiness, the ΔTTV, the amount of metal adhesion with the wafer surface of the resulting wafer was measured by the following test methods. The obtained results were summarized in Table 1.

### Example 4:

An etching solution was prepared same as Example 1 but the concentration of sodium nitrate was 5 wt%. Moreover, the etching process of the silicon wafer was conducted same as Example 1. The etching rate, the visible test, the roughness, the glossiness, the ΔTTV, the amount of metal adhesion with the wafer surface of the resulting wafer was measured by the following test methods. The obtained results were summarized in Table 1.

### Example 5:

An etching solution was prepared same as Example 1 but the concentration of sodium nitrate was 10 wt%. Moreover, the etching process of the silicon wafer was conducted same as Example 1. The etching rate, the visible test, the roughness, the glossiness, the ΔTTV, the amount of metal adhesion with the wafer surface of the resulting wafer was measured by the following test methods. The obtained results were summarized in Table 1.

### Example 6:

An etching solution was prepared same as Example 3 but the concentration of sodium hydroxide was 30 wt%. Moreover, the etching process of the silicon wafer was conducted same as Example 1. The etching rate, the visible test, the roughness, the glossiness, the ΔTTV, the amount of metal adhesion with the wafer surface of the resulting wafer was measured by the following test methods. The obtained results were summarized in Table 1.

### Example 7:

An etching solution was prepared same as Example 2 but sodium nitrate was replaced by potassium nitrate. Moreover, the etching process of the silicon wafer was conducted same as Example 1. The etching rate, the visible test, the roughness, the glossiness, the ΔTTV, the amount of metal adhesion with the wafer surface of the resulting wafer was measured by the following test methods. The obtained results were summarized in Table 1.

### Example 8:

An etching solution was prepared same as Example 2 but sodium nitrate was replaced by lithium nitrate. Moreover, the etching process of the silicon wafer was conducted same as Example 1. The etching rate, the visible test, the roughness, the glossiness, the ΔTTV, the amount of metal adhesion with the wafer surface of the resulting wafer was measured by the following test methods. The obtained results were summarized in Table 1.

### Example 9:

An etching solution was prepared same as Example 2 but the concentration of sodium hydroxide was 51 wt%. Moreover, the etching process of the silicon wafer was conducted same as Example 1. The etching rate, the visible test, the roughness, the glossiness, the ΔTTV, the amount of metal adhesion with the wafer surface of the resulting wafer was measured by the following test methods. The obtained results were summarized in Table 1.

### Comparative example 1:

An etching solution was prepared same as Example 1 without adding nitrate additives. Moreover, the etching process of a silicon wafer was conducted same as Example 1. The etching rate, the visible test, the roughness, the glossiness, the ΔTTV, the amount of metal adhesion with the wafer surface of the resulting wafer was measured by the following test methods. The obtained results were summarized in Table 1. A photograph at the visual check and measured results of uneven etching on the surface of the wafer observed by an electronic microscope (1250 ×) were shown in Figure 2.

### Comparative example 2:

An etching solution was prepared same as Example 9 without adding nitrate additives. Moreover, the etching process of the silicon wafer was conducted same as Example 1. The etching rate, the visible test, the roughness, the glossiness, the ΔTTV, the amount of metal adhesion with the wafer surface of the resulting wafer was measured by the following test methods. The obtained results were summarized in Table 1.

### Comparative example 3:

An etching solution was prepared same as Example 2 high-purity sodium hydroxide was replaced by sodium hydroxide having several dozen ppb of conventional heavy metal and several ppm of variety of salts. Moreover, the etching process of a silicone wafer was conducted same as Example 1. The etching rate, the visible test, the roughness, the glossiness, the ΔTTV, the amount of metal adhesion with the wafer surface of the resulting wafer was measured by the following test methods. The obtained results were summarized in Table 1.

**Table 1:**

| Examples | etching rate [µm/m in] | presence or absence of uneven etching at visible test | roughness (Ra) [µm] | glossiness [%] | ΔTTV [µm] | the amount of metal adhesion [E9 atoms/cm2] | | |
|---|---|---|---|---|---|---|---|---|
| | | | | | | Fe | Ni | Cu |
| Examples 1 | 2.89 | absence | 0.36 | 123.4 | 0.33 | A | A | A |
| Examples 2 | 2.89 | absence | 0.34 | 112.0 | 0.23 | B | A | A |
| Examples 3 | 2.78 | absence | 0.30 | 97.8 | 0.18 | A | A | A |
| Examples 4 | 2.45 | absence | 0.24 | 85.3 | 0.15 | B | A | A |
| Examples 5 | 2.32 | absence | 0.23 | 82.6 | 0.11 | A | A | A |
| | | | | | | | | |
| Examples 6 | 3.34 | absence | 0.38 | 155.9 | 0.64 | A | A | A |
| Examples 7 | 3.04 | absence | 0.26 | 90.6 | 0.20 | B | A | A |
| | | | | | | | | |
| Examples 8 | 2.85 | absence | 0.30 | 100.1 | 0.26 | A | A | A |
| Examples 9 | 2.78 | absence | 0.27 | 127.2 | 0.16 | A | A | A |
| Comparative example 1 | 2.91 | presence | 0.47 | 123.2 | 4.10 | B | A | A |
| Comparative example 2 | 2.56 | presence | 0.45 | 132.1 | 2.90 | A | A | A |
| Comparative example 3 | 2.21 | absence | 0.27 | 98.7 | 0.17 | D | C | C |

| | | | | | | | | |
|---|---|---|---|---|---|---|---|---|
| the amount of metal adhesion unit: [E9 atoms/cm²] A = from the lower than detection limit or more to less than 100 B = from 100 or more to less than 500 C = from 500 or more to less than 1000 D = 1000 or more | | | | | | | | |

The silicon wafer produced in the present invention not only has extremely low amount of metal impurities contamination but also has very excellent surface flatness.

### Fig. 1:

Figure 1 shows an electronic microscope photograph of the wafer surface obtained in Example 2.

### Fig. 2:

Figure 2 shows an electronic microscope photograph of the wafer surface obtained in comparative Example 1.

## Claims

1. A method of etching a silicon wafer comprising
providing a high-purity sodium hydroxide solution containing 40 to 60 wt% of high-purity sodium hydroxide;
providing an alkali etching solution by adding 0.01 to 10 wt% of nitrate of sodium, potassium or lithium to the high-purity sodium hydroxide solution;
wherein the high-purity sodium hydroxide contains:
1 ppb or less of the element content of Cu, Ni, Mg and Cr,
5 ppb or less of the element content of Pb and Fe,
10 ppb or less of the element content of Al, Ca and Zn and
1 ppm or less of chloride, sulfate, phosphate and nitrogen compound; and
contacting the silicon wafer with the alkali etching solution.

## Patentansprüche

1. Verfahren zum Ätzen einer Siliciumscheibe, bei dem man eine Lösung von hochreinem Natriumhydroxid, die 40 bis 60 Gew.-% hochreines Natriumhydroxid enthält, bereitstellt;
durch Zugabe von 0,01 bis 10 Gew.-% Natrium-, Kalium- oder Lithiumnitrat zu der Lösung von hochreinem Natriumhydroxid eine Alkaliätzlösung bereitstellt;
wobei das hochreine Natriumhydroxid:
1 ppb oder weniger des Elementgehalts von Cu, Ni, Mg und Cr,
5 ppb oder weniger des Elementgehalts von Pb und Fe,
10 ppb oder weniger des Elementgehalts von Al, Ca und Zn und
1 ppm oder weniger Chlorid, Sulfat, Phosphat und Stickstoffverbindung
enthält; und
die Siliciumscheibe mit der Alkaliätzlösung in Berührung bringt.

## Revendications

1. Procédé de gravure d'une tranche de silicium comprenant
l'obtention d'une solution d'hydroxyde de sodium de haute pureté contenant 40 à 60 % en poids d'hydroxyde de sodium de haute pureté ;
l'obtention d'une solution de gravure alcaline par addition de 0,01 à 10 % en poids de nitrate de sodium, de potassium ou de lithium à la solution d'hydroxyde de sodium de haute pureté ;
dans lequel l'hydroxyde de sodium de haute pureté contient :
1 ppb ou moins de teneur en éléments Cu, Ni, Mg et Cr,
5 ppb ou moins de teneur en éléments Pb et Fe,
10 ppb ou moins de teneur en éléments Al, Ca et Zn, et
1 ppm ou moins de composés de chlorure, sulfate, phosphate et azote ; et
la mise en contact de la tranche de silicium avec la solution de gravure alcaline.
